# FASCICULE DE BREVET EUROPEEN

(11) **EP 1 010 198 B1**
(45) Date de publication et mention de la délivrance du brevet: **30.04.2008**
(21) Numéro de dépôt: 98942724.0
(22) Date de dépôt: 11.08.1998
(51) Int. Cl.: H01L 21/20, H01L 21/762

(54) **PROCEDE DE FABRICATION D'UN FILM MINCE DE MATERIAU SOLIDE**
HERSTELLUNGSVERFAHREN FÜR EINEN DÜNNFILM AUS FESTEM MATERIAL
METHOD FOR MAKING A THIN FILM OF SOLID MATERIAL

(30) Priorité: 12.08.1997 FR 9710288
(43) Date de publication de la demande: 21.06.2000
(73) Titulaire: COMMISSARIAT A L'ENERGIE ATOMIQUE, 75015 Paris (FR)
(72) Inventeur: ASPAR, Bernard, F-38140 Rives (FR); BRUEL, Michel, F-38113 Veurey (FR)
(74) Mandataire: Weber, Etienne Nicolas
(86) Numéro de dépôt international: PCT/FR1998/001789
(87) Numéro de publication internationale: WO 1999/008316

(56) Documents cités:
- EP-A- 0 786 801
- FR-A- 2 681 472
- BRUEL M: "APPLICATION OF HYDROGEN ION BEAMS TO SILICON ON INSULATOR MATERIAL TECHNOLOGY" NUCLEAR INSTRUMENTS & METHODS IN PHYSICS RESEARCH, SECTION - B: BEAM INTERACTIONS WITH MATERIALS AND ATOMS, vol. 108, no. 3, février 1996, pages 313-319, XP000611125

## Description

### Domaine technique

La présente invention concerne un procédé de fabrication d'un film mince de matériau solide. Ce procédé permet en particulier le transfert d'un film mince de matériau solide homogène ou hétérogène sur un support constitué d'un matériau solide de même nature ou de nature différente.

### Etat de la technique antérieure

Le document FR-A-2 681 472 décrit un procédé de fabrication de films minces de matériau semiconducteur. Ce document divulgue que l'implantation d'un gaz rare ou d'hydrogène dans un substrat en matériau semiconducteur est susceptible de créer la formation de microcavités ou de microbulles (encore désignées par le terme "platelets" dans la terminologie anglo-saxonne) à une profondeur voisine de la profondeur moyenne de pénétration des ions implantés. Si ce substrat est mis en contact intime, par sa face implantée avec un raidisseur et qu'un traitement thermique est appliqué à une température suffisante, il se produit une interaction entre les microcavités ou les microbulles conduisant à une séparation du substrat semiconducteur en deux parties : un film mince semiconducteur adhérent au raidisseur d'une part, le reste du substrat semiconducteur d'autre part. La séparation a lieu à l'endroit où les microcavités ou microbulles sont présentes. Le traitement thermique est tel que l'interaction entre les microbulles ou microcavités créées par implantation induit une séparation entre le film mince et le reste du substrat. Il y a donc transfert d'un film mince depuis un substrat initial jusqu'à un raidisseur servant de support à ce film mince.

Ce procédé peut également s'appliquer à la fabrication d'un film mince de matériau solide autre qu'un matériau semiconducteur (un matériau conducteur ou diélectrique), cristallin ou non.

Si le film mince délimité dans le substrat est suffisamment rigide par lui-même (à cause de son épaisseur ou à cause de ses propriétés mécaniques) on peut obtenir, après le recuit de transfert, un film autoporté. C'est ce qu'enseigne le document FR-A-2 738 671.

Par contre, en l'absence de raidisseur, si le film est trop mince pour induire la fracture sur toute la largeur du substrat, des bulles apparaissent à la surface traduisant la présence de microfissures au niveau de la profondeur moyenne d'implantation des ions. Dans ce cas, le traitement thermique ne produit pas de couches autoportées mais produit uniquement des copeaux.

Dans le document FR-A-2 681 472, le traitement thermique est défini à partir de la température de recuit, dans une étape postérieure à l'étape d'implantation, cette température de recuit étant supérieure à la température d'implantation et devant être telle qu'elle provoque la séparation entre le film mince et le reste du substrat.

Les documents cités plus haut spécifient que le traitement thermique est mené à une température supérieure à la température d'implantation. Le document FR-A-2 681 472 indique que, dans le cas d'un substrat en silicium la température d'implantation est de préférence comprise entre 20°C et 450°C et que, pour le recuit, une température supérieure, est nécessaire (par exemple une température de 500°C).

Cependant, dans certains cas et pour certaines applications, une température de traitement thermique élevée peut présenter des inconvénients. En effet, il peut être avantageux d'obtenir un clivage du substrat à des températures considérées comme basses, en particulier à des températures inférieures à la température d'implantation. Ceci est important notamment dans le cas où le transfert met en présence des matériaux à coefficients de dilatation thermique différents.

Il peut être avantageux d'effectuer l'étape d'implantation ionique à une température élevée, et qui peut être plus élevée que la température prévue pour l'étape de traitement thermique. L'intérêt de ceci réside dans le fait que, s'il n'y a pas de contrainte sur la température d'implantation, une forte densité de courant d'implantation peut être obtenue sans être obligé de refroidir le substrat. Les durées d'implantation sont alors fortement diminuées.

Par ailleurs, entre l'étape d'implantation ionique et l'étape de traitement thermique (ou recuit) provoquant le clivage, on peut être amené à traiter la face implantée, par exemple en vue de créer des circuits électroniques dans le cas d'un substrat en matériau semiconducteur. Or, ces traitements intermédiaires peuvent être altérés si la température de recuit est trop élevée.

### Exposé de l'invention

L'invention permet de résoudre ces problèmes de l'art antérieur. Les inventeurs de la présente invention ont en effet découvert qu'il est possible de baisser la température de recuit si l'on tient compte du budget thermique fourni au substrat au cours des différentes étapes du procédé (étape d'implantation ionique, étape éventuelle d'adhésion du substrat sur le raidisseur, traitements intermédiaires éventuels, étape de recuit permettant la séparation). Par budget thermique, on entend que, pour une étape où un apport thermique est apporté (par exemple lors de l'étape de recuit), il ne faut pas raisonner uniquement sur la température mais sur le couple temps-température fourni au substrat.

A titre d'exemple, pour un substrat en silicium faiblement dopé, implanté avec une dose de 5, 5.10¹⁶ ions H⁺/cm² d'énergie 69 keV, à une température de 80°C pendant environ 5 minutes, le clivage apparaît pour un budget thermique, dans le cas d'un recuit isotherme, qui dépend comme on l'a vu du couple temps-température. Ce budget thermique est de 2 h 15 min à 450°C. Si la dose implantée est plus importante par exemple pour un substrat en silicium faiblement dopé implanté avec une dose de 10¹⁷ ions H⁺/cm² à 69 keV à une température de 80°C pendant 5 mn, le budget thermique nécessaire pour obtenir le clivage est inférieur au précédent. Ce budget est par exemple de 2 mn 22 s à 450°C ou de 1 h 29 mn à 300°C. Ainsi, le clivage se produit pour des budgets thermiques, dans le cas d'un recuit isotherme, qui sont différents des cas précédents mais qui dépendent toujours du couple temps-température. Le choix des budgets thermiques peut dépendre également du type de matériau et de son niveau de dopage lorsque ce dernier est dopé.

A titre d'exemple pour du silicium fortement dopé (par exemple 10²⁰ bore/cm³) que l'on implante avec une dose de 5,5.10¹⁶ ions H⁺/cm² d'énergie 69 keV, à une température de 80°C pendant 5 mn, le clivage est obtenu pour un budget thermique de 4 mn 15 s à 300°C ou 1 h 43 mn à 225°C.

Dans le cas où le traitement thermique est réalisé à l'aide d'une montée progressive en température, il faut tenir compte du budget thermique appliqué aux substrats pendant cette montée en température car il contribue au clivage.

De façon générale, le choix du budget thermique à utiliser pour obtenir la fracture dépend de l'ensemble des budgets thermiques appliqués au matériau de base ou à la structure à partir de l'étape d'implantation. Tous ces budgets thermiques constituent un bilan thermique qui permet d'atteindre le clivage de la structure. Ce bilan thermique est formé par au moins deux budgets thermiques : celui de l'implantation et celui du recuit.

Il peut comporter, en fonction des applications, d'autres types de budgets par exemple : un budget thermique pour renforcer les liaisons moléculaires à l'interface de collage ou pour créer ces liaisons, un ou plusieurs budgets thermiques pour la réalisation d'éléments actifs.

L'invention a donc pour objet un procédé de fabrication d'un film mince de matériau solide selon la revendication 1.

On définit le terme de clivage au sens large, c'est-à-dire tout type de fracture.

Le procédé selon l'invention permet la réalisation d'un film mince de matériau solide, cristallin ou non, qui peut être un matériau conducteur, un matériau semiconducteur ou un matériau diélectrique. Le substrat de matériau solide peut se présenter sous la forme d'une couche. Le budget thermique prévu pour l'étape de recuit prend également en compte des paramètres de l'étape d'implantation tels que la dose d'ions implantés et l'énergie.

Les ions susceptibles d'être implantés sont avantageusement des ions de gaz rares ou d'hydrogène. La direction d'implantation des ions peut être normale à la face du substrat ou légèrement inclinée.

Par hydrogène, on entend les espèces gazeuses constituées soit sous leur forme atomique (par exemple H) ou sous leur forme moléculaire (par exemple H₂) ou sous leur forme ionique (H⁺, H₂⁺, ...) ou sous leur forme isotopique (Deutérium) ou isotopique et ionique, ...

Le budget thermique de l'étape de recuit peut être également prévu pour obtenir ledit clivage du substrat soit naturellement, soit à l'aide de contraintes appliquées au substrat.

Le budget thermique de l'étape de recuit peut comporter au moins une montée rapide en température et/ou au moins une descente rapide en température. Ces variations rapides en température s'échelonnent de quelques degrés par minute à quelques dizaines voire quelques centaines de degrés par seconde (recuits de type RTA pour "Rapid Thermal Annealing"). Ces recuits peuvent présenter un avantage pour certaines conditions d'implantation car ils facilitent l'étape de formation (ou nucléation) des microcavités.

Le budget thermique de l'étape de recuit peut aussi être nul, le clivage du substrat s'obtenant par l'utilisation de contraintes mécaniques et/ou thermiques. En effet, le budget thermique étant une fonction de la température appliquée et de la durée, le budget thermique de l'étape de recuit peut donc avoir une température qui varie par exemple de 0°C à plus de 1000°C et une durée qui varie de 0 seconde à plusieurs heures. Ainsi, si les budgets thermiques précédant l'étape de recuit sont réalisés avec des températures et/ou des durées importantes et si les doses et l'énergie des ions implantés sont importantes (par exemple pour du silicium quelques 10¹⁷ H⁺/cm² avec une énergie de 100 keV), le budget thermique de recuit peut même être nul aussi bien en durée qu'en température. De simples contraintes permettent alors le clivage. Ces contraintes sont par exemple de type mécanique (par exemple forces de cisaillement et/ou de traction) ou de type thermique (par exemple par refroidissement de la structure).

Le procédé peut comprendre en outre une étape de fixation de la face implantée du substrat sur un support. La fixation de la face implantée du substrat sur le support peut se faire au moyen d'une substance adhésive. L'étape de fixation peut inclure un traitement thermique.

L'étape de recuit peut être menée par chauffage impulsionnel.

Le procédé selon la présente invention s'applique en particulier à la fabrication d'un film mince de silicium monocristallin. Dans ce cas, avant d'obtenir le clivage du substrat, tout ou partie d'au moins un élément actif peut être réalisé dans la partie du substrat destinée à former le film mince. Si ladite face du substrat est masquée avant l'étape d'implantation ionique, le "masque" est tel que pour que l'étape d'implantation ionique soit apte à créer des zones de microcavités ou de microbulles suffisamment proches les unes des autres pour que ledit clivage puisse être obtenu.

Le procédé selon la présente invention s'applique également à la fabrication d'un film mince à partir d'un substrat dont ladite face présente des motifs.

Il s'applique également à la fabrication d'un film mince à partir d'un substrat comprenant des couches de natures chimiques différentes.

Il s'applique aussi à la fabrication d'un film mince à partir d'un substrat comprenant au moins une couche obtenue par croissance. Cette croissance peut être obtenue par épitaxie, la fracture pouvant avoir lieu dans la couche épitaxiée ou au-delà de la couche épitaxiée ou encore à l'interface.

L'invention sera mieux comprise à la lecture de la description qui va suivre, donnée à titre d'exemple non limitatif.

### Description détaillée de modes de réalisation de l'invention

Un premier mode de réalisation de l'invention prévoit de réaliser l'étape d'implantation à température relativement élevée.

Afin d'augmenter la productivité des équipements, et en particulier des implanteurs, il apparaît intéressant d'utiliser des machines délivrant une forte densité de courant. Par exemple, des courants de 4 mA sur une surface de 100 cm² permettant d'obtenir des doses de 5.10¹⁶ ions H⁺/cm² en 200 secondes soit environ 3 minutes. Si cette implantation est effectuée à 50 keV (ce qui donne une profondeur moyenne de l'ordre de 500 nm), on obtient une puissance de l'ordre de 2 W/cm², ce qui dans le cas du silicium et pour un implanteur classique sans refroidissement conduit à des températures de l'ordre de 470°C.

En résumé dans ce cas, la dose nécessaire à l'implantation a été obtenue pour une implantation à une température de l'ordre de 470°C et un temps de l'ordre de 3 minutes.

Si un raidisseur est appliqué à ce substrat et qu'un traitement thermique de recuit d'environ 1 heure à 450°C est réalisé sur cette structure, le budget thermique du traitement thermique est tel que les microcavités peuvent interagir entre elles et conduire à la fracture. On obtiendra ainsi le transfert du film mince du silicium sur son raidisseur.

Cet exemple montre bien que si certaines précautions sont prises au niveau des budgets thermiques appliqués au substrat au cours de l'implantation et du traitement thermique, il est possible d'obtenir le clivage à une température inférieure à la température d'implantation.

En conclusion, l'invention consiste à effectuer un traitement thermique avec un budget thermique minimum et tel qu'il conduit au clivage. Ce budget thermique minimum doit tenir compte de l'ensemble des budgets et notamment du budget thermique fourni par l'implantation et du budget thermique fourni par le recuit.

Un deuxième mode de réalisation de l'invention s'applique au transfert de matériaux présentant des coefficients de dilatation thermique différents de ceux de leurs supports. C'est le cas des hetérostructures.

Dans le cas d'un transfert de silicium sur de la silice pure, le raidisseur a un coefficient de dilatation thermique différent de celui du matériau semiconducteur. Or, les budgets thermiques permettant le transfert du silicium monocristallin dans le cas du silicium faiblement dopé sont de l'ordre de quelques heures (6 heures) 450°C. A cette température, il se produit un décollement du substrat et du support (raidisseur) mis en contact intime, au cours du recuit. Ce décollement se produit au niveau de l'interface de mise en contact et non au niveau de la couche où sont localisées les microcavités ou les microbulles. Par contre, si l'épaisseur du support en silice est suffisamment faible (par exemple 400 µm), l'ensemble ne se décolle pas jusqu'à 250°C. Or, dans le cas où le silicium est fortement dopé (par exemple un dopage de type p de 10²⁰ atomes de bores/cm²) le clivage peut être obtenu pour un budget thermique de 250°C pendant 1 heure et pour une implantation d'ions hydrogène d'une dose de l'ordre de 5.10¹⁶ ions H⁺/cm². Comme il a été dit plus haut, de telles doses peuvent être obtenues avec des temps de l'ordre de quelques minutes dans le cas d'une température d'implantation d'environ 470°C.

Dans ce cas également, le clivage est obtenu pour une température de recuit inférieure à la température d'implantation.

## Revendications

1. Procédé de fabrication d'un film mince de matériau solide à partir d'un substrat dudit matériau solide, comprenant des étapes au cours desquelles :
- le substrat subit une implantation ionique au travers de l'une de ses faces au moyen d'ions aptes à créer, dans le volume du substrat et à une profondeur voisine de la profondeur moyenne de pénétration des ions, une couche de microcavités ou de microbulles,
- la couche de microcavités ou de microbulles reçoit un apport thermique,
- un clivage du substrat de part et d'autre de la couche de microcavités ou de microbulles est réalisé pour fournir le film mince,
- éventuellement, le film mince délimité par l'implantation ionique subit un ou plusieurs traitements intermédiaires entre l'implantation ionique et le clivage,
**caractérisé en ce que** l'apport thermique est réparti dans les différentes étapes du procédé sous la forme de budgets thermiques, chaque budget thermique consistant à porter le substrat à une température déterminée pendant un temps déterminé et chaque budget thermique étant choisi tel que le clivage du substrat est obtenu au cours d'une étape de recuit dont la température est inférieure à la température de l'étape d'implantation.

2. Procédé selon la revendication 1, **caractérisé en ce que** le clivage du substrat est obtenu au cours d'une étape de recuit dont le budget thermique est déterminé pour obtenir ledit clivage du substrat soit naturellement, soit à la suite de contraintes appliquées au substrat.

3. Procédé selon la revendication 2, **caractérisé en ce que** le budget thermique de l'étape de recuit comporte au moins une montée rapide en température et/ou au moins une descente rapide en température.

4. Procédé selon la revendication 1, **caractérisé en ce que** le clivage du substrat est obtenu par l'utilisation de contraintes mécaniques et/ou thermiques au cours d'une étape où le budget thermique est nul.

5. Procédé selon l'une quelconque des revendications 1 à 4, **caractérisé en ce qu'**il comprend en outre une étape de fixation de la face implantée du substrat sur un support.

6. Procédé selon la revendication 5, **caractérisé en ce que** la fixation de la face implantée du substrat sur le support se fait au moyen d'une substance adhésive.

7. Procédé selon l'une des revendications 5 ou 6, **caractérisé en ce que** l'étape de fixation inclut un traitement thermique.

8. Procédé selon la revendication 5, **caractérisé en ce que** l'étape de fixation est réalisée par adhésion moléculaire.

9. Procédé selon la revendication 2, **caractérisé en ce que** l'étape de recuit est menée par chauffage impulsionnel.

10. Procédé selon la revendication 1, **caractérisé en ce que** le film mince de matériau solide est fabriqué à partir d'un substrat en silicium et **en ce que** les ions implantés comprennent des ions hydrogène.

11. Application du procédé selon l'une quelconque des revendications précédentes à la fabrication d'un film mince de silicium monocristallin.

12. Application selon la revendication 11, **caractérisée en ce que**, avant d'obtenir le clivage du substrat, tout ou partie d'au moins un élément actif est réalisé dans la partie du substrat destinée à former le film mince.

13. Application selon l'une des revendications 11 ou 12, **caractérisée en ce que**, ladite face du substrat étant masquée avant l'implantation ionique, le masque est tel que l'implantation ionique est apte à créer des zones de microcavités ou de microbulles suffisamment proches les unes des autres pour que ledit clivage puisse être obtenu.

14. Application du procédé selon la revendication 11 à la fabrication d'un film mince à partir d'un substrat dont ladite face présente des motifs.

15. Application du procédé selon la revendication 11 à la fabrication d'un film mince à partir d'un substrat comprenant des couches de natures chimiques différentes.

16. Application du procédé selon la revendication 11 à la fabrication d'un film mince à partir d'un substrat comprenant au moins une couche obtenue par croissance.

17. Application selon la revendication 16, **caractérisée en ce que** ladite croissance est obtenue par épitaxie.

18. Application selon la revendication 11, **caractérisée en ce que** les ions implantés dans le substrat comprennent des ions hydrogène.

## Claims

1. Method of manufacturing a thin film of solid material from a substrate of said solid material, comprising steps during which:
- the substrate undergoes ion implantation through one of its faces by means of ions able to create, in the volume of the substrate and at a depth close to the average depth of penetration of ions, a layer of micro-cavities or micro-bubbles,
- the layer of micro-cavities or micro-bubbles receives a heat supply,
- a cleaving of the substrate on either side of the layer of micro-cavities or micro-bubbles is carried out in order to supply the thin film,
- optionally, the thin film defined by ion implantation undergoes one or more intermediate treatments between ion implantation and cleaving, **characterized in that** the heat supply is distributed over the different steps of the method in the form of thermal budges, each thermal budget consisting of bringing the substrate to a given temperature during a given time and each thermal budget is chosen so that the cleaving of the substrate is obtained during an annealing step, whose temperature is below the temperature of the implantation step.

2. Method according to claim 1, **characterized in that** the cleaving of the substrate is obtained during an annealing step, whose thermal budget is determined for obtaining said cleaving of the substrate either naturally, or following stresses applied to the substrate.

3. Method according to claim 2, **characterized in that** the thermal budget of the annealing step includes at least one rapid rise in temperature and/or at least one rapid fall in temperature.

4. Method according to claim 1, **characterized in that** the thermal budget of the annealing step is zero, the cleavage of the substrate being obtained by the use of mechanical and/or thermal stresses.

5. Method according to any one of claims 1 to 4, **characterized in that** it includes in addition a step of fixing the implanted face of the substrate onto a support.

6. Method according to claim 5, **characterized in that** the fixing of the implanted face of the substrate onto the support is done by means of an adhesive substance.

7. Method according to claim 5, **characterized in that** the fixing step incudes a heat treatment.

8. Method according to claim 5, **characterized in that** the fixing step is carried out by molecular adhesion.

9. Method according to claim 2, **characterized in that** the annealing step is carried out by pulsed heating.

10. Method according to claim 1, **characterized in that** the thin solid material film is produced from a silicon substrate and **in that** the implanted ions include hydrogen ions.

11. Application of the method according to any one of the preceding claims to the production of a thin film of mono-crystalline silicon.

12. Application according to claim 11, **characterized in that**, before obtaining the cleavage of the substrate, all or part of at least one active element is created in the part of the substrate intended to form the thin film.

13. Application according to one of claims 11 or 12, **characterized in that**, said face of the substrate, being masked before the ionic implantation step, the mask is such that the ionic implantation step is capable of creating zones of micro-cavities or micro-bubbles sufficiently close to one another that said cleavage can be obtained.

14. Application of the method according to claim 11 to the production of a thin film starting from a substrate whose face is patterned.

15. Application of the method according to claim 11 to the production of a thin film starting from a substrate that includes layers of different chemical kinds.

16. Application of the method according to claim 11 to the production of a thin film starting from a substrate that includes at least one layer obtained by growth.

17. Application according to claim 16, **characterized in that** said growth is obtained by epitaxy.

18. Application according to claim 11, **characterized in that** the ions implanted in the substrate include hydrogen ions.

## Patentansprüche

1. Herstellungsverfahren eines Dünnfilms aus festem Material aus einem Substrat des genannten festen Materials, folgende Schritte umfassend:
- man unterzieht das Substrat auf einer seiner Seiten einer lonenimplantation, deren Ionen fähig sind, in dem Volumen des Substrats und in einer ungefähr der mittleren Eindringtiefe der Ionen entsprechenden Tiefe eine Mikrohohlräume- oder Mikroblasenschicht zu erzeugen,
- man führt der Mikrohohlräume- oder Mikroblasenschicht Wärme zu,
- man spaltet, um den Dünnfilm zu erhalten, das Substrat beiderseits der Mikrohohlräume- oder Mikroblasenschicht,
- eventuell unterzieht man den durch die lonenimplantation abgegrenzten Dünnfilm zwischen der lonenimplantation und der Spaltung einer oder mehreren Zwischenbehandlungen,
**dadurch gekennzeichnet, dass** die Wärmezufuhr in Form von Wärmebudgets auf die verschiedenen Schritte des Verfahrens verteilt ist, wobei jedes Wärmebudget darin besteht, das Substrat während einer bestimmten Zeit auf eine bestimmte Temperatur zu bringen, und jedes Wärmebudget so gewählt wird, dass die Spaltung des Substrats während eines Temperschritts stattfindet, dessen Temperatur niedriger ist als die Temperatur des Implantationsschritts.

2. Verfahren nach Anspruch 1, **dadurch gekennzeichnet, dass** die Spaltung des Substrats während eines Temperschritts erfolgt, dessen Wärmebudget so festgelegt ist, dass die Spaltung des Substrats entweder natürlich oder als Folge von Spannungen stattfindet, denen man das Substrat aussetzt.

3. Verfahren nach Anspruch 2, **dadurch gekennzeichnet, dass** das Wärmebudget des Temperschritts wenigstens einen schnellen Temperaturanstieg und/oder wenigstens einen schnellen Temperaturabfall umfasst.

4. Verfahren nach Anspruch 1, **dadurch gekennzeichnet, dass** man die Spaltung des Substrats durch die Anwendung mechanischer und/oder thermischer Spannungen im Verlauf eines Schritts bewirkt, wo das Wärmebudget null ist.

5. Verfahren nach einem der Ansprüche 1 bis 4, **dadurch gekennzeichnet, dass** es außerdem einen Schritt zur Befestigung der implantierten Seite des Substrats auf einem Träger umfasst.

6. Verfahren nach Anspruch 5, **dadurch gekennzeichnet, dass** die Befestigung der implantierten Seite des Substrats auf dem Träger mit Hilfe einer Adhäsionssubstanz erfolgt.

7. Verfahren nach einem der Ansprüche 5 oder 6, **dadurch gekennzeichnet, dass** der Befestigungsschritt eine Wärmebehandlung einschließt.

8. Verfahren nach Anspruch 5, **dadurch gekennzeichnet, dass** der Befestigungsschritt durch Molekularadhäsion realisiert wird.

9. Verfahren nach Anspruch 2, **dadurch gekennzeichnet, dass** der Temperschritt mittels Impulsheizung durchgeführt wird.

10. Verfahren nach Anspruch 1, **dadurch gekennzeichnet, dass** der Dünnfilm aus festem Material ausgehend von einem Siliciumsubstrat hergestellt wird, und **dadurch**, dass die implantierten Ionen Wasserstoffionen umfassen.

11. Anwendung des Verfahrens nach einem der vorangehenden Ansprüche zur Herstellung eines Dünnfilms aus monokristallinem Silicium.

12. Anwendung nach Anspruch 11, **dadurch gekennzeichnet, dass** man vor der Spaltung des Substrats in dem zur Bildung des Dünnfilms bestimmten Teil des Substrats mindestens ein aktives Element realisiert.

13. Anwendung nach einem der Ansprüche 11 oder 12, **dadurch gekennzeichnet, dass** die genannte Seite des Substrats vor der lonenimplantation maskiert wird, wobei die Maske so ist, dass die lonenimplantation fähig ist, Mikrohohlräume- oder Mikroblasenzonen zu erzeugen, die einander ausreichend nahe sind, damit die genannte Spaltung realisiert werden kann.

14. Anwendung nach Anspruch 11 zur Herstellung eines Dünnfilms aus einem Substrat, dessen genannte Seite Muster aufweist.

15. Anwendung nach Anspruch 11 zur Herstellung eines Dünnfilms aus einem Substrat, das Schichten von unterschiedlicher chemischer Art umfasst.

16. Anwendung nach Anspruch 11 zur Herstellung eines Dünnfilms aus einem Substrat, das mindestens eine durch Wachstum erzeugte Schicht umfasst.

17. Anwendung nach Anspruch 16, **dadurch gekennzeichnet, dass** das genannte Wachstum durch Epitaxie erzeugt wird.

18. Anwendung nach Anspruch 11, **dadurch gekennzeichnet, dass** die in das Substrat implantierten Ionen Wasserstoff-Ionen umfassen.
